# FASCICULE DE BREVET EUROPEEN

(11) **EP 3 017 548 B1**
(45) Date de publication et mention de la délivrance du brevet: **19.03.2025**
(21) Numéro de dépôt: 14736726.2
(22) Date de dépôt: 02.07.2014
(51) Int. Cl.: H03M 7/40, H04Q 9/00

(54) **PROCÉDÉ DE MISE À DISPOSITION PAR UN COMPTEUR ÉLECTRIQUE DE DONNÉES COMPRESSÉES**
VERFAHREN ZUR HERSTELLUNG VON DURCH EINEN ELEKTRISCHEN ZÄHLER VERFÜGBAREN KOMPRIMIERTEN DATEN
METHOD OF MAKING COMPRESSED DATA AVAILABLE BY AN ELECTRICAL METER

(30) Priorité: 05.07.2013 FR 1356631
(43) Date de publication de la demande: 11.05.2016
(73) Titulaire: Sagemcom Energy & Telecom SAS, 92270 Bois-Colombes (FR)
(72) Inventeur: PIGEON, Nicolas, 92500 Rueil Malmaison (FR)
(74) Mandataire: Cabinet Le Guen Maillet
(86) Numéro de dépôt international: PCT/EP2014/064034
(87) Numéro de publication internationale: WO 2015/000943

(56) Documents cités:
- US-A1- 2013 028 095
- "Handbook of Data Compression Fifth Edition", 31 December 2010, SPRINGER, article DAVID SALOMON: "Handbook of Data Compression Fifth Edition", pages: 55 - 61, XP055689140
- DAVID SALOMON: "Data compression: the complete reference, 3rd Edition", 1 January 2004, DATA COMPRESSION : THE COMPLETE REFERENCE, SPRINGER VERLAG, NEW YORK, NY, US, PAGE(S) 51 - 55, XP002567706
- MICHEL P TCHEOU ET AL: "Optimum Rate-Distortion Dictionary Selection for Compression of Atomic Decompositions of Electric Disturbance Signals", IEEE SIGNAL PROCESSING LETTERS, IEEE, USA, vol. 14, no. 2, 1 February 2007 (2007-02-01), pages 81 - 84, XP011155968, ISSN: 1070-9908, DOI: 10.1109/LSP.2006.882117
- ANONYMOUS: "Smart meter", INTERNET CITATION, 27 October 2010 (2010-10-27), pages 1 - 10, XP002671945, Retrieved from the Internet <URL:http://en.wikipedia.org/w/index.php?title=Smart_meter&oldid=393257694> [retrieved on 20120321]
- SALOMON D ED - SALOMON D: "Data Compression, Run-Length Encoding", 1 January 2007, DATA COMPRESSION : THE COMPLETE REFERENCE, SPRINGER VERLAG, LONDEN, GB, PAGE(S) 22 - 23,26, ISBN: 978-1-84628-602-5, XP002527126

## Description

La présente invention concerne une compression de données de mesure par un compteur électrique, lesdites données étant typiquement destinées à être transmises par le compteur électrique à un concentrateur de données par courants porteurs en ligne (« powerline communications » en anglais) ou par un autre biais.

Dans le cadre d'un réseau d'alimentation électrique de type AMM (« Automated Meter Management » en anglais), des communications sont établies entre des compteurs électriques, dits intelligents (« smart meters » en anglais), et un concentrateur de données (« data concentrator » en anglais), parfois appelé *nœud de base* (« base node » en anglais), en charge de collecter des données de mesures effectuées par les compteurs électriques, typiquement de l'énergie consommée par des installations électriques respectivement supervisées par lesdits compteurs électriques. Les échanges entre les compteurs électriques et le concentrateur de données s'appuient sur des communications par courants porteurs en ligne (« Powerline Communications » en anglais).

Les compteurs électriques actuels comportent aussi généralement une interface de télé-information client (TIC) permettant de récupérer les données de mesures effectuées par les compteurs électriques. Les échanges via l'interface TIC sont opérés sous la forme d'un signal modulé de type ASK (« Amplitude Shift Keying » en anglais). Le document extrait de l'encyclopédie en ligne Wikipédia intitulé « smart meter » d'un auteur anonyme et publié du 27 octobre 2010), décrit une mise à disposition par un compteur électrique de données de mesure. Ces données sont issues de mesures effectuées par le compteur électrique sur une consommation énergétique d'une installation électrique supervisée par le compteur électrique.

Dans chacun des cas cités ci-dessus, une large quantité de données peuvent être à transférer par le compteur électrique. De plus, pour pouvoir être transmises au concentrateur de données par communications par courants porteurs en ligne ou pour pouvoir être transmises à un dispositif connecté à l'interface TIC, ces données doivent être stockées.

Il est alors souhaitable de trouver une solution qui puisse permettre de compresser ces données en vue de leur stockage et/ou de leur transmission, de manière à préserver respectivement des ressources mémoire et/ou accélérer leur transfert. L'article de revue intitulé « Data compression : the complete reference, 3rd edition » de David Salomon et publié le 01 janvier 2004, décrit des exemples d'algorithmes de compression de données, en particulier des codes préfixes.

Il est aussi souhaitable de fournir une solution qui soit simple à mettre en œuvre.

L'invention concerne un procédé de mise à disposition par un compteur électrique de données de mesure, lesdites données étant issues de mesures de quantité d'énergie effectuées par ledit compteur électrique sur une consommation énergétique d'une installation électrique supervisée par ledit compteur électrique, le compteur électrique récupérant les données de mesure à mettre à disposition. Le procédé est tel que le compteur électrique effectue en outre les étapes suivantes : classifier chaque donnée récupérée, en fonction d'un nombre minimum de bits pour représenter ladite donnée ; déterminer, pour chaque classe d'une pluralité prédéfinie de classes, un nombre de bits affectés pour représenter chaque donnée classifiée dans ladite classe, en fonction des nombres minimums de bits pour respectivement représenter les données classifiées dans ladite classe ; compresser chaque donnée de mesure récupérée, en représentant ladite donnée récupérée sur un nombre de bits égal au nombre de bits affectés à la classe de ladite donnée de mesure et en insérant avant la donnée compressée un préfixe prédéfini associé à ladite classe ; et, inclure dans un entête associé aux données compressées, pour chaque classe, une information représentative du nombre de bits affectés pour représenter chaque donnée de mesure classifiée dans ladite classe. Le compteur électrique effectue les étapes suivantes : déterminer la valeur la plus récurrente parmi les données de mesure récupérées ; et remplacer les données de mesure, de valeur égale à la valeur la plus récurrente déterminée, par un unique bit. Ainsi, les ressources nécessaires pour mettre à disposition lesdites données de mesure sont significativement réduites.

Selon un mode de réalisation particulier, les données de mesure étant représentées sous forme absolue, le compteur électrique effectue une étape préalable de conversion des données de mesure sous forme absolue en données de mesure sous forme relative. Ainsi, les ressources nécessaires pour mettre à disposition lesdites données de mesure sont encore significativement réduites.

Selon un mode de réalisation particulier, le compteur électrique utilise un code binaire tronqué pour identifier les données de mesure ayant ladite valeur la plus récurrente et les préfixes. Ainsi, il est possible de se passer de préfixe pour les données de mesure dont la valeur est égale à la valeur la plus récurrente déterminée.

Selon un mode de réalisation particulier, les données de mesure étant associées à au moins une information d'horodatage représentative d'un instant absolu, le compteur électrique effectue une étape de conversion de ladite information d'horodatage en une information relative par rapport à une date prédéfinie. Ainsi, les ressources nécessaires pour mettre à disposition de telles informations d'horodatage sont significativement réduites.

Selon un mode de réalisation particulier, chaque donnée de mesure étant associée à une information d'horodatage, les mesures effectuées par le compteur électrique étant périodiques, le compteur électrique ne conserve qu'une information d'horodatage et inclut dans l'entête une information représentative de la périodicité desdites mesures. Ainsi, les ressources nécessaires pour mettre à disposition de telles informations d'horodatage sont encore significativement réduites.

Selon un mode de réalisation particulier, pour indiquer un changement de référence temporelle parmi les données de mesure, le compteur électrique effectue les étapes suivantes : déterminer un index de chaque donnée de mesure pour laquelle le changement de référence temporelle est intervenu ; déterminer un décalage temporel dû au changement de référence temporelle pour ladite donnée de mesure dont l'index a été ainsi déterminé ; et, inclure dans l'entête des informations représentatives dudit index et dudit décalage temporel. Ainsi, les ressources nécessaires pour mettre à disposition de telles informations d'horodatage sont significativement réduites, malgré le changement de référence temporelle (*e*.*g*. passage heure d'été / heure d'hiver).

Selon un mode de réalisation particulier, le compteur électrique, considérant les données de mesure comme des données non signées, effectue les étapes suivantes : déterminer un nombre minimum de bits pour représenter la valeur la plus élevée parmi les données de mesure ; affecter ledit nombre minimum de bits déterminé à une première classe ; tester, pour chaque autre classe de ladite pluralité prédéfinie, une valeur de bits affectés pour représenter les données de ladite classe, et déterminer une taille résultante des données de mesure après compression ; et, affecter à chaque autre classe de ladite pluralité prédéfinie un nombre de bits permettant d'obtenir la taille résultante des données de mesure, après compression, la plus faible. Ainsi, la détermination dynamique des bits affectés aux classes est simple à mettre en œuvre.

Selon un mode de réalisation particulier, les données de mesure étant signées, le compteur électrique effectue les étapes suivantes : déterminer un premier nombre minimum de bits pour représenter la valeur absolue la plus élevée parmi les données positives de mesure ; déterminer un second nombre minimum de bits pour représenter la valeur absolue la plus élevée parmi les données négatives de mesure ; affecter ledit premier nombre minimum de bits déterminé à une première classe ; affecter ledit second nombre minimum de bits déterminé à une seconde classe ; tester, pour chaque autre classe de ladite pluralité prédéfinie, une valeur de bits affectés pour représenter les données de ladite classe, et déterminer une taille résultante des données de mesure après compression ; affecter à chaque autre classe de ladite pluralité prédéfinie un nombre de bits permettant d'obtenir la taille résultante des données de mesure, après compression, la plus faible ; et inclure dans l'entête une information indiquant quelle(s) classe(s) concerne(nt) des données positives de mesure et quelle(s) classe(s) concerne(nt) des données négatives de mesure. Ainsi, la compression des données de mesure est plus efficace lorsque les données de mesure sont signées.

Selon un mode de réalisation particulier, les données de mesure étant signées, le compteur électrique effectue préalablement les étapes suivantes : déterminer une valeur de recalage égale à la valeur absolue la plus élevée parmi les données négatives de mesure ; ajouter la valeur de recalage à chacune des données de mesure ; et inclure dans l'entête une information représentative de la valeur de recalage. Ainsi, les données de mesure sont transformées en données positives de mesure (donc équivalentes à des données non signées), ce qui simplifie et augmente l'efficacité de la compression en présence de données signées de mesure.

Selon un mode de réalisation particulier, pour mettre à disposition lesdites données de mesure, le compteur électrique s'attendant à recevoir un mot de passe prédéfini, ledit compteur électrique effectue les étapes suivantes : recevoir un mot de passe ; déterminer une valeur inversée du mot de passe reçu ; mettre à disposition lesdites données de mesure sous forme compressée, lorsque la valeur inversée du mot de passe reçu correspond audit mot de passe prédéfini ; et, mettre à disposition lesdites données de mesure sous forme non compressée, lorsque le mot de passe reçu correspond audit mot de passe prédéfini. Ainsi, un seul mot de passe a besoin d'être configuré, et le support des dispositifs disponibles sur étagère (« off-the-shelf devices » en anglais) est assuré.

L'invention concerne également un compteur électrique adapté pour mettre à disposition des données de mesure, lesdites données étant issues de mesures de quantité d'énergie effectuées par ledit compteur électrique sur une consommation énergétique d'une installation électrique supervisée par ledit compteur électrique, le compteur électrique comportant des moyens pour récupérer les données de mesure à mettre à disposition. Le compteur électrique est tel qu'il comporte en outre : des moyens pour classifier chaque donnée de mesure récupérée, en fonction d'un nombre minimum de bits pour représenter ladite donnée ; des moyens pour déterminer, pour chaque classe d'une pluralité prédéfinie de classes, un nombre de bits affectés pour représenter chaque donnée classifiée dans ladite classe, en fonction des nombres minimums de bits pour respectivement représenter les données classifiées dans ladite classe ; des moyens pour compresser chaque donnée de mesure récupérée, en représentant ladite donnée de mesure récupérée sur un nombre de bits égal au nombre de bits affectés à la classe de ladite donnée et en insérant avant la donnée compressée un préfixe prédéfini associé à ladite classe ; et des moyens pour inclure dans un entête associé aux données compressées, pour chaque classe, une information représentative du nombre de bits affectés pour représenter chaque donnée classifiée dans ladite classe. Le compteur électrique comporte en outre : des moyens pour déterminer la valeur la plus récurrente parmi les données de mesure récupérées ; et des moyens pour remplacer les données de mesure, de valeur égale à la valeur la plus récurrente déterminée, par un unique bit.

L'invention concerne également un programme d'ordinateur, qui peut être stocké sur un support et/ou téléchargé d'un réseau de communication, afin d'être lu par un processeur. Ce programme d'ordinateur comprend des instructions pour implémenter le procédé mentionné ci-dessus, lorsque ledit programme est exécuté par le processeur. L'invention concerne également des moyens de stockage comprenant un tel programme d'ordinateur.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :
- la Fig. 1 illustre schématiquement un système électrique dans lequel l'invention peut être mise en œuvre ;
- la Fig. 2 illustre schématiquement un exemple de tout ou partie d'une architecture matérielle d'un dispositif du système électrique, tel qu'un compteur électrique ;
- la Fig. 3 illustre schématiquement un algorithme, mis en œuvre par un compteur électrique, de traitement d'une requête d'envoi de données de mesure ;
- la Fig. 4 illustre schématiquement un algorithme, mis en œuvre par le compteur électrique, de compression de données de mesure ;
- la Fig. 5 illustre schématiquement un algorithme, mis en œuvre par le compteur électrique, pour déterminer si le compteur électrique doit envoyer les données sous forme compressée ou sous forme non compressée.

L'invention est décrite en détail ci-après dans un contexte de transfert de données de mesure depuis un compteur électrique vers un concentrateur de données via des communications à courants porteurs en ligne. Les principes de compression des données fournies par le compteur électrique sont toutefois applicables de la même manière au moment du stockage desdites données par le compteur électrique ou pour transférer lesdites données via une interface de télé-information client. Les principes de compression des données fournies par le compteur électrique sont aussi applicables de la même manière dans un contexte de transfert de données de mesure depuis un compteur électrique vers un concentrateur de données via un autre support, comme par exemple via GPRS (« General Packet Radio Service » en anglais). D'une manière générale, les principes de compression décrits ici concernent la mise à disposition de données de mesure par le compteur électrique.

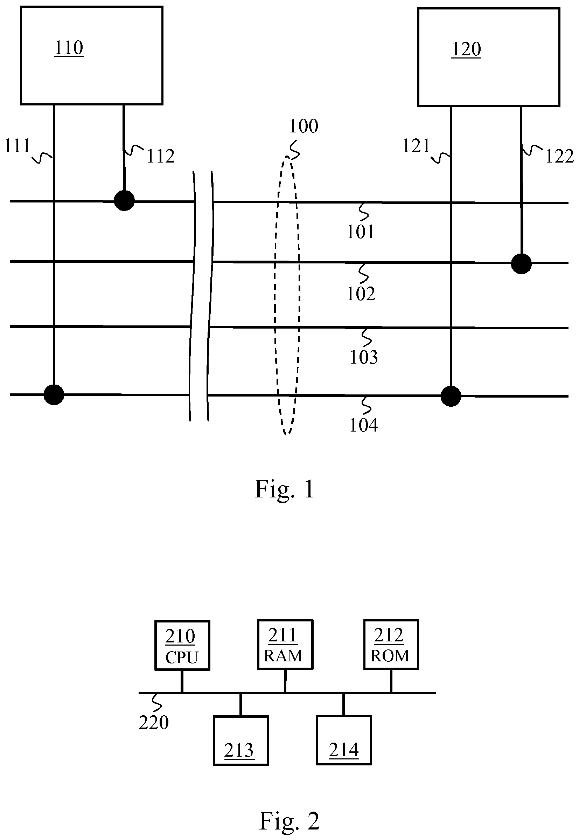

La Fig. 1 illustre schématiquement un système électrique dans lequel l'invention peut être mise en œuvre.

Le système électrique de la Fig. 1 comporte un réseau d'alimentation électrique 100 constitué d'une pluralité de fils, un fil étant dédié au neutre et au moins un fil étant dédié à au moins une phase. Dans l'exemple de réalisation représenté par la Fig. 1, le réseau d'alimentation électrique 100 est un système à trois phases, et est donc constitué de quatre fils: un fil de neutre 104, un fil d'une première phase 101, un fil d'une seconde phase 102 et un fil de troisième phase 103. La séparation des phases est donc de 120 degrés entre les deux phases, et serait de 180 degrés dans le cas d'un système à deux phases, puisque dans les réseaux électriques polyphasés, les phases sont en général à égale distance angulaire.

Le système électrique de la Fig. 1 comporte en outre un compteur électrique 120, c'est-à-dire un dispositif servant à mesurer la quantité d'énergie électrique consommée par une installation électrique que le compteur électrique 120 est en charge de superviser. Le compteur électrique 120 est connecté à un des fils de phase du réseau d'alimentation électrique 100 ainsi qu'au fil de neutre, par des liens respectifs 122 et 121. On est, dans ce cas, en présence d'un compteur électrique monophasé. Le système électrique de la Fig. 1 pourrait reposer sur une mise en œuvre d'un compteur électrique polyphasé.

Le système électrique de la Fig. 1 comporte en outre un concentrateur de données 110 en charge de collecter des données de mesure, ces mesures étant effectuées par les compteurs électriques connectés au réseau d'alimentation électrique 100. Le concentrateur de données 110 est connecté à un des fils de phase du réseau d'alimentation électrique 100 ainsi qu'au fil de neutre, par des liens respectifs 112 et 111. On voit sur l'exemple de la Fig. 1 que le concentrateur de données 110 et le compteur électrique 120 sont connectés au réseau d'alimentation électrique 100 via des phases distinctes. Le concentrateur de données 110 et le compteur électrique 120 pourraient être connectés au réseau d'alimentation électrique 100 via une même phase.

Les échanges entre le compteur électrique 120 et le concentrateur de données 110 sont opérés par courants porteurs en ligne (« powerline communications » en anglais). Par exemple, ces échanges sont opérés selon les spécifications PRIME (« *PoweRline Intelligent Metering Evolution* » en anglais). Ces échanges permettent au concentrateur de données 110 de requérir, auprès du compteur électrique 120, un envoi de données de mesure correspondant à des mesures, faites par le compteur électrique 120, de consommation énergétique de l'installation électrique supervisée par le compteur électrique 120.

La Fig. 2 illustre schématiquement un exemple d'architecture matérielle d'au moins une partie du compteur électrique 120 et/ou du concentrateur de données 110.

Considérons la Fig. 2 dans le cadre du compteur électrique 120. Le compteur électrique 120 comprend alors, reliés par un bus de communication 220: un processeur ou CPU (« Central Processing Unit » en anglais) 210 ; une mémoire vive RAM (« Random Access Memory » en anglais) 211 ; une mémoire morte ROM (« Read Only Memory » en anglais) 212 ; une unité de stockage ou un lecteur de support de stockage, tel qu'un lecteur de cartes SD (« Secure Digital » en anglais) 213 ; un ensemble 214 d'interfaces de connexion permettant de connecter le compteur électrique 120 au réseau d'alimentation électrique 100.

Le processeur 210 est capable d'exécuter des instructions chargées dans la RAM 211 à partir de la ROM 212, d'une mémoire externe (non représentée), d'un support de stockage, tel qu'une carte SD, ou d'un réseau de communication. Lorsque le compteur électrique 120 est mis sous tension, le processeur 210 est capable de lire de la RAM 211 des instructions et de les exécuter. Ces instructions forment un programme d'ordinateur causant la mise en œuvre, par le processeur 210, de tout ou partie des algorithmes et étapes décrits ci-après.

Tout ou partie des algorithmes et étapes décrits ci-après peut être implémenté sous forme logicielle par exécution d'un ensemble d'instructions par une machine programmable, par exemple un DSP (« Digital Signal Processor » en anglais) ou un microcontrôleur, ou être implémenté sous forme matérielle par une machine ou un composant dédié, par exemple un FPGA (« Field-Programmable Gate Array » en anglais) ou un ASIC (« Application-Specific Integrated Circuit » en anglais).

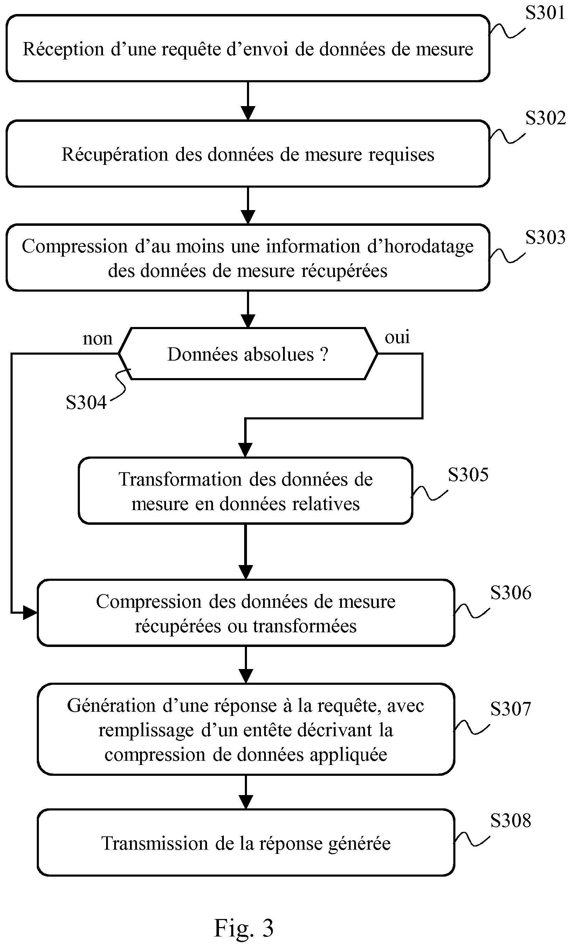

La Fig. 3 illustre schématiquement un algorithme, mis en œuvre par le compteur électrique 120, de traitement d'une requête d'envoi de données de mesure en provenance du concentrateur de données 110.

Dans une étape S301, le compteur électrique 120 reçoit la requête d'envoi de données de mesure en provenance du concentrateur de données 110. Un type peut être associé à chaque requête d'envoi de données de mesure, lorsque le compteur électrique 120 est adapté à transmettre différents types de données de mesure. Par exemple, un premier type de requête concerne l'envoi de données de mesure correspondant à un bilan hebdomadaire ou mensuel de consommation d'énergie par l'installation électrique supervisée par le compteur électrique 120. Par exemple, un second type de requête concerne l'envoi de données de mesure correspondant à des points discrets d'une courbe de charge accumulée de l'installation électrique supervisée par le compteur électrique 120.

Dans une étape S302 suivante, le compteur électrique 120 récupère les données de mesure à transmettre au concentrateur de données 110. Ces données de mesure correspondent à des résultats de mesures instantanées et/ou à des résultats de mesures accumulées et/ou à un ensemble de mesures régulières. Ces mesures sont effectuées par le compteur électrique 110 sur requête du concentrateur de données 110 (*e.g.* mesures instantanées) ou de manière autonome par le compteur électrique 110 (*e.g.* mesures régulières ou accumulées). Ces mesures concernent typiquement la quantité d'énergie électrique et/ou la puissance électrique consommées par l'installation électrique supervisée par le compteur électrique 120. Lorsque le compteur électrique effectue de telles mesures, ledit compteur électrique 120 stocke les résultats de ces mesures dans une mémoire non volatile. A l'étape S302, le compteur électrique 120 lit cette mémoire non volatile de manière à récupérer au moins une partie de ces résultats stockés.

Dans une étape S303 optionnelle suivante, lorsque les données de mesures sont associées à au moins une information d'horodatage, le compteur électrique 120 procède à une compression de ladite ou desdites information(s) d'horodatage. On peut trouver une unique information d'horodatage pour l'ensemble des données de mesure à transmettre au concentrateur de données 110. C'est le cas par exemple lorsque le concentrateur de données 110 requiert l'envoi d'un bilan hebdomadaire ou mensuel de consommation d'énergie par l'installation électrique supervisée par le compteur électrique 120. On peut trouver une pluralité d'informations d'horodatage pour l'ensemble des données de mesure à transmettre au concentrateur de données 110, typiquement une information d'horodatage par donnée de mesure à transmettre. C'est le cas par exemple lorsque le concentrateur de données 110 requiert l'envoi de points discrets de courbe de charge accumulée de l'installation électrique supervisée par le compteur électrique 120.

Ainsi, dans l'étape S303, le compteur électrique 120 transforme chaque information d'horodatage exprimée sous forme absolue en une information d'horodatage exprimée sous forme relative par rapport à une date prédéfinie connue du compteur électrique 120 et du concentrateur de données. Le compteur électrique 120 compresse ainsi chaque information d'horodatage. L'unité utilisée pour la forme relative peut être la seconde, mais est préférentiellement la minute pour une collecte de données de mesure de compteur électrique.

Dans les compteurs électriques intelligents actuels, une telle information d'horodatage est une information absolue de date représentée sur 14 octets. Il est alors possible de coder cette information d'horodatage sous forme relative sur 28 ou 32 bits, en prenant comme unité la minute, ce qui permet de couvrir une plage temporelle bien au delà de la durée de vie des installations électriques.

Dans un mode de réalisation particulier, lorsque les données à transmettre au concentrateur de données 110 correspondent à des mesures périodiques et que chaque donnée est associée à une information d'horodatage représentative d'un instant auquel ladite mesure a été faite par le compteur électrique 120, le compteur électrique 120 ne garde que l'information d'horodatage associée à une mesure et supprime les autres informations d'horodatage. Soit le concentrateur de données 110 a connaissance de la périodicité des mesures effectuées par le compteur électrique 111, soit le compteur électrique 120 fournit une information représentative de cette périodicité au concentrateur de données 110 en association avec lesdites données de mesure, préférentiellement dans un entête associé auxdites données de mesure. Dans un mode de réalisation encore plus particulier, lorsqu'au moins une discontinuité temporelle existe entre l'information d'horodatage d'une donnée et l'information d'horodatage de la donnée suivante (rupture de périodicité des mesures par rapport à la référence temporelle, comme c'est le cas lors d'un passage en heure d'été ou en heure d'hiver), le compteur électrique 120 identifie à quel index intervient cette discontinuité temporelle au sein des données de mesure et détermine quel décalage temporel (signé) intervient à cette discontinuité. Le compteur électrique 120 transmet alors au concentrateur de données 110, pour chaque discontinuité temporelle identifiée, de préférence dans un entête associé aux données de mesure après compression, des informations représentatives de cet index et de ce décalage temporel.

Dans une étape S304 suivante, le compteur électrique 120 vérifie si les données de mesure à transmettre au concentrateur de données 110 sont exprimées sous forme absolue, c'est-à-dire indépendamment les unes des autres, ou sous forme relative, c'est-à-dire que la première mesure est typiquement fournie sous forme absolue et les mesures suivantes sont fournies sous forme d'un écart avec les mesures respectives précédentes. Si les données de mesure sont exprimées sous forme absolue, une étape S305 est effectuée ; sinon, une étape S306 est effectuée.

Dans l'étape S305, le compteur électrique 120 transforme les données de mesure exprimées sous forme absolue en données de mesure exprimées sous forme relative. Préférentiellement, la première mesure est conservée sous forme absolue et, pour les mesures suivantes, les écarts non signés entre lesdites mesures et les mesures respectives précédentes sont déterminés et stockés en remplacement desdites mesures. L'étape S306 est ensuite effectuée.

Lorsqu'il est prédéfini que les données de mesure sont exprimées sous forme relative, le compteur électrique 120 peut passer directement de l'étape S303 à l'étape S306. Lorsqu'il est prédéfini que les données de mesure sont exprimées sous forme absolue, le compteur électrique 120 peut passer directement de l'étape S303 à l'étape S305.

Dans l'étape S306, le compteur électrique 120 effectue une compression des données de mesure à transmettre au concentrateur de données 110.

Lorsque les données de mesure sont non signées, la probabilité qu'un nombre élevé de ces données de mesure comporte plusieurs bits successifs de poids forts à « 0 » est grande. Plutôt que de représenter toutes les données non signées de mesure avec un même nombre de bits, typiquement 32 bits, il est possible de représenter ces données de mesure sur des nombres de bits différents. De la même manière, lorsque les données de mesure sont négatives, la probabilité qu'un nombre élevé de ces données de mesure comporte plusieurs bits successifs de poids forts à « 1 » est grande. Plutôt que de représenter toutes les données négatives de mesure avec un même nombre de bits, typiquement 32 bits, il est possible de représenter ces données de mesure sur des nombres de bits différents. On limite ainsi le nombre de bits non significatifs transmis.

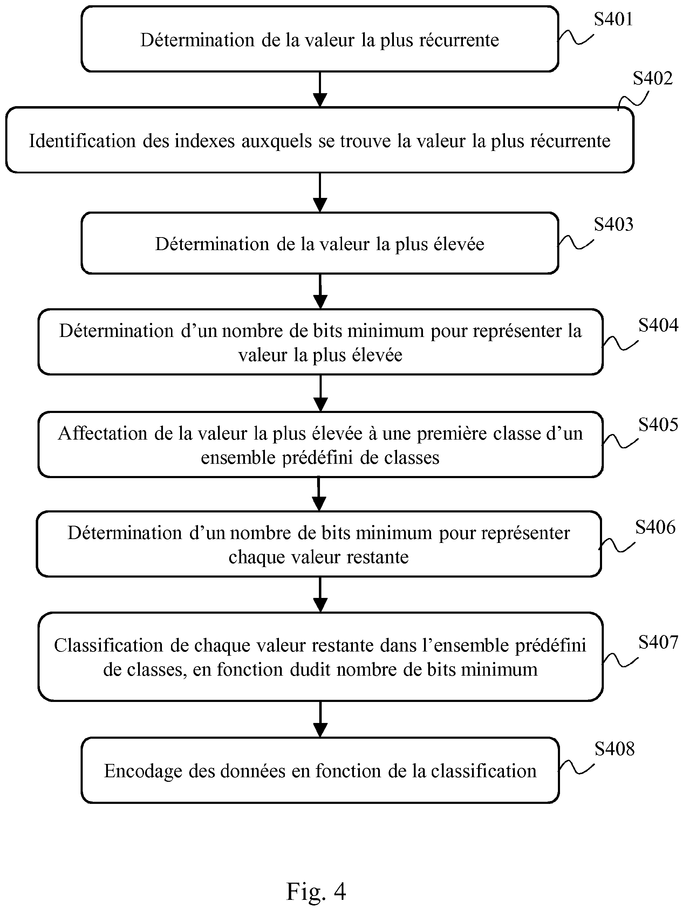

Pour ce faire, le compteur électrique 120 classifie chaque donnée de mesure, en fonction d'un nombre minimum de bits pour représenter ladite donnée de mesure ; les bits de poids forts non significatifs ne sont ainsi pas pris en compte. Ensuite, le compteur électrique 120 détermine, pour chaque classe d'une pluralité prédéfinie de classes, un nombre de bits affectés pour représenter chaque donnée classifiée dans ladite classe, en fonction du nombre minimum de bits pour représenter les données classifiées dans ladite classe. En d'autres termes, le nombre de bits nécessaires pour représenter toutes les données classifiées dans une classe est égal au maximum des nombres minimums de bits déterminés pour les données classifiées dans ladite classe. Le nombre de classes disponibles est donc prédéfini, mais pas le nombre de bits pour représenter les données de la classe, qui a besoin d'être dynamiquement déterminé. Ensuite, le compteur électrique 120 compresse chaque donnée de mesure, en représentant ladite donnée de mesure sur un nombre de bits égal au nombre de bits affectés à la classe de ladite donnée de mesure et en insérant avant ladite donnée compressée un préfixe prédéfini associé à ladite classe. En d'autres termes, le compteur électrique 120 génère un train de bits qui est une succession de préfixes et de données de mesure compressées, chaque préfixe représentant une classe dans laquelle la donnée de mesure qui suit ledit préfixe a été classifiée, chaque donnée compressée étant représentée sur un nombre de bits affectés par le compteur électrique 120 à ladite classe. Un mode de réalisation particulier de l'étape S306 est détaillé ci-après en relation avec la Fig. 4.

Lorsque les données de mesure sont signées, et que ces données de mesure peuvent donc être positives, nulles ou négatives, plusieurs options alternatives peuvent être mises en œuvre.

Selon un premier mode de réalisation, lorsque les données de mesure sont signées, le compteur électrique 120 effectue la classification et la compression de données comme si les données de mesure étaient non signées. Ce mode de réalisation est particulièrement avantageux lorsque les données positives de mesure sont plus nombreuses que les données négatives de mesure. Dans le cas où les données négatives de mesure sont plus nombreuses que les données positives de mesure, le compteur électrique 120 peut inverser (complément à 1) les données de mesure et indiquer dans un entête qu'une telle inversion a été appliquée.

Selon un second mode de réalisation, lorsque les données de mesure sont signées, le compteur électrique 120 dédie une ou plusieurs classes à la compression des données négatives de mesure et une ou plusieurs classes à la compression des données positives de mesure. Une telle répartition des classes peut être prédéfinie ou dynamiquement déterminée. Si cette répartition des classes est dynamiquement déterminée, le compteur électrique 120 fournit dans un entête une information représentative de quelle répartition est appliquée.

Selon un troisième mode de réalisation, lorsque les données de mesure sont signées, le compteur électrique 120 peut repasser toutes les données de mesure en positif. Pour ce faire, le compteur électrique 120 détermine quelle la donnée négative de mesure dont la valeur absolue est la plus grande. Cette valeur absolue définit une valeur de recalage des données de mesure. Le compteur électrique 120 ajoute alors, à chaque donnée de mesure, la valeur de recalage. Les valeurs des données de mesure deviennent alors toutes positives, donc non signées. Le compteur électrique 120 fournit alors dans un entête une information représentative de cette valeur de recalage.

Dans une étape S307 suivante, le compteur électrique 120 génère une réponse à la requête reçue à l'étape S301. La réponse générée inclut les données de mesure obtenues après compression et éventuellement au moins une information d'horodatage compressée. La réponse générée inclut un entête décrivant la compression de données appliquée à l'étape S306, et indiquant plus particulièrement, pour chaque classe, le nombre de bits affectés pour représenter les données de mesure compressées de ladite classe. Le nombre de classes utilisables étant prédéfini, un champ peut être préétabli pour chaque classe dans l'entête pour décrire le nombre de bits affectés pour représenter les données de mesure compressées de ladite classe. Comme déjà mentionné, l'entête peut en outre inclure une information indiquant pour chaque classe si ladite classe concerne des données positives de mesure ou des données négatives de mesure. Comme déjà mentionné, l'entête peut en outre inclure une information de recalage permettant de transformer toutes les données de mesure en données positives de mesure. Comme déjà mentionné, l'entête peut en outre inclure une information de périodicité des mesures effectuées par le compteur électrique 120. Comme déjà mentionné, l'entête peut en outre inclure des informations d'index et de décalage temporel représentatives d'au moins une discontinuité temporelle au sein des données de mesure. L'entête inclut en outre une information représentative du nombre de données de mesure incluses dans la réponse. Le compteur électrique 120 peut ajouter des bits de remplissage (« padding » en anglais) à la suite des données de mesure compressées de manière à permettre un alignement sur 8, 16 ou 32 bits de la réponse générée. Le compteur électrique 120 peut en outre ajouter une information de contrôle de redondance cyclique CRC (« Cyclic Redundancy Checksum » en anglais) permettant au concentrateur de données 110 de contrôler l'intégrité de la réponse à la réception. Le compteur électrique 120 peut en outre ajouter une information de numéro de série du compteur électrique 120 pour permettre au concentrateur de données 110 de vérifier l'authenticité des données reçues.

La Fig. 4 illustre schématiquement un algorithme, mis en œuvre par le compteur électrique 120, de compression de données de mesure. Dans le cadre de l'algorithme de la Fig. 4, il est considéré que le compteur électrique 120 peut classifier les données de mesure dans au moins deux classes distinctes : une première classe est adaptée pour représenter la valeur la plus élevée et au moins une seconde classe permet de représenter des données sur un nombre de bits inférieur au nombre minimum de bits pour représenter la valeur la plus élevée. Dans le cadre de l'algorithme de la Fig. 4, le compteur électrique 120 considère que les données de mesure sont non signées, que ces données de mesure soient effectivement non signées ou pas.

Dans une étape S401, le compteur électrique 120 détermine la valeur la plus récurrente parmi les données de mesure à transmettre au concentrateur de données 110. Dans un mode de réalisation particulier, le compteur électrique 120 a connaissance, de manière prédéfinie, de la valeur *a priori* la plus récurrente parmi les données de mesure. Dans les données actuellement transmises par les compteurs électriques, la valeur *a priori* la plus récurrente parmi les données de mesure est « 0 ».

Dans une étape S402 suivante, le compteur électrique 120 identifie les indexes des données de mesure égales à ladite valeur la plus récurrente, afin de pouvoir remplacer chacune de ces données de mesure par un seul bit dans une étape ultérieure de compression.

Dans une étape S403 suivante, le compteur électrique 120 détermine la valeur la plus élevée parmi les données de mesure à transmettre au concentrateur de données 110. Si la valeur la plus élevée parmi les données de mesure est égale à la valeur la plus récurrente, le compteur électrique 120 effectue directement une étape S406 (non représenté sur la Fig. 4).

Dans une étape S404 suivante, le compteur électrique 120 détermine un nombre minimum de bits pour représenter la valeur la plus élevée parmi les données de mesure.

Dans une étape S405 suivante, le compteur électrique 120 affecte la valeur la plus élevée parmi les données de mesure à la première classe de données de mesure. Cela définit le nombre maximum de bits pour représenter chaque donnée de mesure à transmettre au concentrateur de données 110 en réponse à la requête reçue à l'étape S301.

Dans une étape S406 suivante, le compteur électrique 120 détermine, pour chaque donnée de mesure restante (*i.e.* en dehors de la valeur la plus récurrente et de la valeur la plus élevée) un nombre minimum de bits pour représenter ladite donnée de mesure.

Dans une étape S407 suivante, le compteur électrique 120 classifie chaque donnée de mesure restante dans la première classe, ou dans la seconde classe ou l'une des secondes classes, en fonction du nombre minimum de bits pour représenter ladite donnée de mesure. Si le même nombre minimum de bits est nécessaire pour représenter la donnée de mesure que pour représenter ladite valeur la plus élevée, alors la donnée de mesure est affectée à la première classe.

Pour déterminer le nombre de bits affectés pour représenter les données de mesure de chaque classe, le compteur électrique 120 peut par exemple procéder de façon exhaustive. Considérons que *i* représente le nombre de bits affectés à l'encodage des données de mesure de la première classe, que j représente le nombre de bits affectés à l'encodage des données de mesure d'une seconde classe et que *k* représente le nombre de bits affectés à l'encodage des données de mesure d'une autre seconde classe. Le compteur électrique 120 teste toutes les combinaisons possibles du triplet *(i,j,k)* et détermine, pour chacune de ces combinaisons, la taille résultante des données de mesure après compression. Il est à noter que *i* est fixé à l'étape S404. Le compteur électrique 120 conserve alors le triplet *(i,j,k)* entraînant la taille résultante la plus faible. Une fois le triplet *(i,j,k)* fixé, il reste au compteur électrique 120 à affecter chaque donnée de mesure à une des classes prédéfinies, en fonction du nombre minimum de bits nécessaire pour représenter ladite donnée : ladite classe est celle dont le nombre de bits affectés est immédiatement supérieur, ou égal, à la valeur de ladite donnée parmi le triplet *(i,j,k).*

Dans une étape S408 suivante, le compteur électrique 120 effectue un encodage de chaque donnée de mesure, en fonction du nombre de bits alloués à chaque donnée de la classe à laquelle est affectée ladite donnée de mesure.

Un préfixe peut être ajouté devant chaque donnée compressée de manière à pouvoir identifier à quelle classe la donnée de mesure a été affectée. Par exemple, si trois classes sont définies et qu'un préfixe est ajouté pour chaque donnée de mesure compressée, un préfixe de deux bits permet d'identifier à quelle classe est affectée ladite donnée de mesure.

Un préfixe peut être ajouté devant chaque donnée compressée de manière à pouvoir identifier à quelle classe la donnée de mesure a été affectée, lorsque ladite donnée de mesure n'a pas la valeur la plus récurrente ; et lorsque ladite donnée de mesure a la valeur la plus récurrente, aucun préfixe n'est nécessaire. Par exemple, dans le cas où quatre classes sont définies, le compteur électrique 120 utilise : un bit de valeur « 0 » pour représenter la valeur la plus récurrente (sans préfixe), la valeur binaire « 10 » comme préfixe d'une valeur compressée d'une autre classe, la valeur binaire « 110 » comme préfixe d'une valeur compressée d'encore une autre classe et la valeur binaire « 111 » comme préfixe d'une valeur compressée de la dernière classe. Ainsi, la valeur la plus récurrente est représentée sur un bit et les autres données de mesure après compression sont précédées d'un préfixe d'au moins deux bits dont le premier bit en séquence est de valeur distincte de celle utilisée pour représenter la valeur la plus récurrente. D'une manière plus générale, un code binaire tronqué peut être utilisé pour identifier les données ayant la valeur la plus récurrente et les préfixes.

Il reste alors au compteur électrique 120 à remplir l'entête à associer aux données de mesure, comme déjà décrit en relation avec la Fig. 3, notamment en indiquant, pour chaque classe, le nombre de bits dynamiquement affectés pour représenter les données de mesure de ladite classe.

Ainsi, lorsque le concentrateur de données 110 reçoit la réponse générée et transmise par le compteur électrique 120, le concentrateur de données 110 analyse l'entête pour retrouver, pour chaque classe prédéfinie, le nombre de bits utilisés pour représenter les données de mesure de ladite classe. Le concentrateur de données analyse alors le train de bits des données de mesure. Si le premier bit est « 0 », alors le concentrateur de données 110 est en présence d'une donnée de mesure égale à la valeur la plus récurrente. Sinon, le concentrateur de données 110 est en présence d'un préfixe associé à une des classes. Le concentrateur de données prend les bits un par un pour retrouver quel préfixe est représenté, en déduit la classe correspondante, récupère dans l'entête le nombre N de bits affectés à cette classe et récupère les N bits suivants du train de bits pour extraire la donnée de mesure correspondante. Le concentrateur de données 110 peut alors convertir la donnée extraite dans son format d'origine.

Lorsque des informations d'horodatage sont associées aux données de mesure, le concentrateur de données 110 peut effectuer l'opération inverse de celle effectuée à l'étape S303 pour convertir les informations d'horodatage sous leur format d'origine. L'entête peut aussi fournir une information de périodicité de mesure pour permettre au concentrateur de données 110 de réassocier une information d'horodatage par donnée non signée de mesure. L'entête peut aussi fournir une information de décalage temporel et d'index pour permettre au concentrateur de données 110 de détecter des changements de référence temporelle.

Dans un mode de réalisation particulier, le compteur électrique 120 tient compte du caractère signé des données de mesure. Le compteur électrique 120 sépare, d'une part, les données positives de mesure, et d'autre part, les données négatives de mesures. Le compteur électrique 120 détermine alors la valeur absolue la plus élevée parmi les données positives de mesure et la valeur absolue la plus élevée parmi les données négatives de mesure. Le compteur électrique 120 détermine un premier nombre minimum de bits pour représenter la valeur absolue la plus élevée parmi les données positives de mesure, et un second nombre minimum de bits pour représenter la valeur absolue la plus élevée parmi les données négatives de mesure. Le compteur électrique 120 affecte ledit premier nombre minimum de bits déterminé à une première classe, et ledit second nombre minimum de bits déterminé à une seconde classe. Le compteur électrique 120 teste ensuite, pour chaque autre classe de ladite pluralité prédéfinie, une valeur de bits affectés pour représenter les données de ladite classe, et détermine une taille résultante des données de mesure après compression. Puis, le compteur électrique 120 affecte à chaque autre classe de ladite pluralité prédéfinie un nombre de bits permettant d'obtenir la taille résultante des données de mesure, après compression, la plus faible. Enfin, le compteur électrique 120 indique dans un entête quelle(s) classe(s) concerne(nt) des données positives de mesure (dont des bits successifs de poids forts égaux à « 0 » sont enlevés par la compression) et quelle(s) classe(s) concerne(nt) des données négatives de mesure (dont des bits successifs de poids forts égaux à « 1 » sont enlevés par la compression).

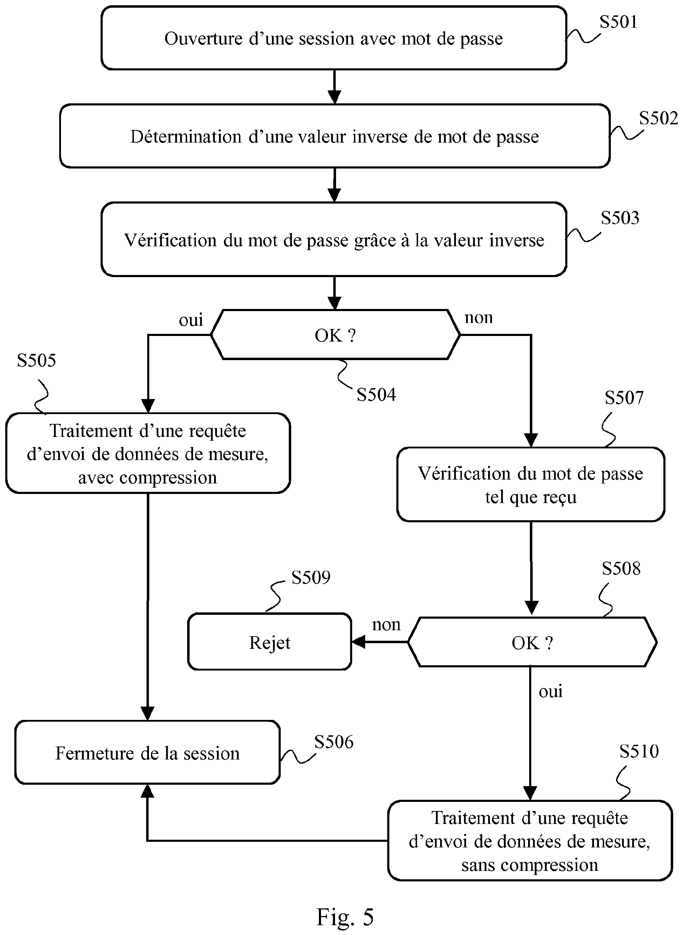

La Fig. 5 illustre schématiquement un algorithme, mis en œuvre par le compteur électrique 120, pour déterminer si le compteur électrique 120 doit envoyer les données sous forme compressée ou sous forme non compressée. Cela permet ainsi au compteur électrique 120 de fonctionner avec un concentrateur de données qui n'est pas adapté pour interpréter les données de mesure après compression. De plus, le principe d'ouverture de session de l'algorithme de la Fig. 5 permet au concentrateur de données 110 de fonctionner avec des compteurs électriques qui ne sont pas adaptés pour compresser les données de mesure.

Dans une étape S501, le compteur électrique 120 reçoit une demande d'ouverture de session en provenance d'un concentrateur de données, tel que le concentrateur de données 110. La demande d'ouverture de session est accompagnée d'un mot de passe.

Dans une étape S502 suivante, le compteur électrique 120 détermine une valeur inverse (« reverse » en anglais) du mot de passe. Par exemple, le mot de passe étant la chaîne de caractères « ABCDEF », la valeur inverse déterminée par le compteur électrique 120 est alors « FEDCBA ». D'autres types de conversion en valeur inverse peuvent être utilisés, par exemple en représentant le mot de passe selon une base binaire et en lisant les bits en sens inverse, ou en passant par une base hexadécimale et en lisant les hexits en sens inverse. D'une manière générale, le compteur électrique 120 applique une transformation prédéfinie du mot de passe reçu pour obtenir un mot de passe transformé.

Dans une étape S503 suivante, le compteur électrique 120 vérifie si le mot de passe inversé (ou, plus généralement, transformé) à l'étape S502 correspond au mot de passe attendu de la part du concentrateur de données 110 pour ouvrir la session. Dans une étape S504, le compteur électrique 120 teste si la vérification est positive. Si tel est le cas, la session est ouverte et une étape S505 est effectuée ; sinon, une étape S507 est effectuée.

Dans l'étape S505, le compteur électrique 120 traite une requête d'envoi de données de mesure. Cette requête peut être reçue par le compteur électrique 120, de la part d'un concentrateur de données, après ouverture de la session. Cette requête peut aussi être implicite à l'ouverture de la session. La requête est traitée conformément à l'algorithme de la Fig. 3, c'est-à-dire avec compression des données de mesure. Ensuite, une étape S506 est effectuée, dans laquelle le compteur électrique 120 ferme la session. Il est alors mis fin à l'algorithme.

Dans l'étape S507, le compteur électrique 120 vérifie si le mot de passe reçu à l'étape S501 correspond au mot de passe attendu de la part du concentrateur de données 110 pour ouvrir la session. Dans une étape S508, le compteur électrique 120 teste si la vérification est positive. Si tel est le cas, la session est ouverte et une étape S510 est effectuée ; sinon, une étape S509 est effectuée, dans laquelle le compteur électrique 120 rejette la demande d'ouverture de session. Il est alors mis fin à l'algorithme.

Dans l'étape S510, le compteur électrique 120 traite une requête d'envoi de données de mesure. Cette requête peut être reçue par le compteur électrique 120, de la part d'un concentrateur de données, après ouverture de la session. Cette requête peut aussi être implicite à l'ouverture de la session. Le compteur électrique 120 récupère les données concernées et transmet ces données, sans compression, au concentrateur de données ayant émis la requête. Ensuite, l'étape S506 est effectuée, et il est mis fin à l'algorithme.

Ainsi, en appliquant l'algorithme de la Fig. 5 et en utilisant un seul mot de passe pour ouvrir une session auprès du compteur électrique 120, le compteur électrique 120 est capable de déterminer si les données de mesure doivent être envoyées au concentrateur de données sous forme compressée ou sous forme non compressée. De plus, en se plaçant du côté du concentrateur de données 110, il est possible de collecter des données, à la fois auprès de compteurs électriques capables de compresser lesdites données et auprès de compteurs électriques incapables de compresser lesdites données. En effet, si le concentrateur de données 110 transmet un mot de passe inversé (ou, plus généralement, transformé en accord avec la fonction appliquée par le compteur électrique 120 à l'étape S502) à un compteur électrique n'implémentant pas de compression des données de mesure, alors ledit compteur électrique va refuser l'ouverture de session. Le concentrateur de données 110 peut alors renouveler sa demande d'ouverture de session avec le mot de passe non inversé (ou, plus généralement, non transformé). Le concentrateur de données 110 peut aussi garder trace du succès ou de l'échec d'une tentative d'ouverture de session avec le mot de passe inversé (ou, plus généralement, transformé), pour envoyer directement le mot de passe approprié lors d'une prochaine ouverture de session avec ce même compteur électrique.

## Revendications

1. Procédé de mise à disposition par un compteur électrique (120) de données de mesure, lesdites données étant issues de mesures de quantité d'énergie électrique effectuées par ledit compteur électrique sur une consommation énergétique d'une installation électrique supervisée par ledit compteur électrique, le compteur électrique récupérant (S302) les données de mesure à mettre à disposition, **caractérisé en ce que** le compteur électrique effectue en outre les étapes suivantes :
- classifier (S405, S407) chaque donnée récupérée, en fonction d'un nombre minimum de bits pour représenter ladite donnée ;
- déterminer (S404, S406), pour chaque classe d'une pluralité prédéfinie de classes, un nombre de bits affectés pour représenter chaque donnée classifiée dans ladite classe égal au maximum des nombres minimums de bits déterminés pour les données classifiées dans ladite classe ;
- compresser (S306 ; S408) chaque donnée de mesure récupérée, en représentant ladite donnée de mesure récupérée sur un nombre de bits égal au nombre de bits affectés à la classe de ladite donnée de mesure et en insérant avant la donnée compressée un préfixe prédéfini associé à ladite classe ; et
- inclure (S307) dans un entête associé aux données compressées, pour chaque classe, une information représentative du nombre de bits affectés pour représenter chaque donnée classifiée dans ladite classe,
et **caractérisé en ce que** le compteur électrique effectue les étapes suivantes :
- déterminer (S401) la valeur la plus récurrente parmi les données de mesure récupérées ; et
- remplacer (S408) les données de mesure, de valeur égale à la valeur la plus récurrente déterminée, par un unique bit.

2. Procédé selon la revendication 1, **caractérisé en ce que**, les données de mesure étant représentées sous forme absolue, le compteur électrique effectue une étape préalable de conversion (S305) des données de mesure sous forme absolue en données de mesure sous forme relative.

3. Procédé selon la revendication 1, **caractérisé en ce que** le compteur électrique utilise un code binaire tronqué pour identifier les données de mesure ayant ladite valeur la plus récurrente et les préfixes.

4. Procédé selon l'une quelconque des revendications 1 à 3, **caractérisé en ce que**, les données de mesure étant associées à au moins une information d'horodatage représentative d'un instant absolu, le compteur électrique effectue une étape de conversion (S303) de ladite information d'horodatage en une information relative par rapport à une date prédéfinie.

5. Procédé selon l'une quelconque des revendications 1 à 4, **caractérisé en ce que**, chaque donnée de mesure étant associée à une information d'horodatage, les mesures effectuées par le compteur électrique étant périodiques, le compteur électrique ne conserve qu'une information d'horodatage et inclut dans l'entête une information représentative de la périodicité desdites mesures.

6. Procédé selon la revendication 5, **caractérisé en ce que**, pour indiquer un changement de référence temporelle parmi les données de mesure, le compteur électrique effectue les étapes suivantes :
- déterminer un index de chaque donnée de mesure pour laquelle le changement de référence temporelle est intervenu ;
- déterminer un décalage temporel dû au changement de référence temporelle pour ladite donnée de mesure dont l'index a été ainsi déterminé ; et
- inclure dans l'entête des informations représentatives dudit index et dudit décalage temporel.

7. Procédé selon l'une quelconque des revendications 1 à 6, **caractérisé en ce que** le compteur électrique, considérant les données de mesure comme des données non signées, effectue les étapes suivantes :
- déterminer (S404) un nombre minimum de bits pour représenter la valeur la plus élevée parmi les données de mesure ;
- affecter (S405) ledit nombre minimum de bits déterminé à une première classe ;
- tester, pour chaque autre classe de ladite pluralité prédéfinie, une valeur de bits affectés pour représenter les données de ladite classe, et déterminer une taille résultante des données de mesure après compression ; et
- affecter à chaque autre classe de ladite pluralité prédéfinie un nombre de bits permettant d'obtenir la taille résultante des données de mesure, après compression, la plus faible.

8. Procédé selon l'une quelconque des revendications 1 à 6, **caractérisé en ce que**, les données de mesure étant signées, le compteur électrique effectue les étapes suivantes :
- déterminer un premier nombre minimum de bits pour représenter la valeur absolue la plus élevée parmi les données positives de mesure ;
- déterminer un second nombre minimum de bits pour représenter la valeur absolue la plus élevée parmi les données négatives de mesure ;
- affecter ledit premier nombre minimum de bits déterminé à une première classe ;
- affecter ledit second nombre minimum de bits déterminé à une seconde classe ;
- tester, pour chaque autre classe de ladite pluralité prédéfinie, une valeur de bits affectés pour représenter les données de ladite classe, et déterminer une taille résultante des données de mesure après compression ;
- affecter à chaque autre classe de ladite pluralité prédéfinie un nombre de bits permettant d'obtenir la taille résultante des données de mesure, après compression, la plus faible ; et
- inclure dans l'entête une information indiquant quelle(s) classe(s) concerne(nt) des données positives de mesure et quelle(s) classe(s) concerne(nt) des données négatives de mesure.

9. Procédé selon l'une quelconque des revendications 1 à 6, **caractérisé en ce que**, les données de mesure étant signées, le compteur électrique effectue préalablement les étapes suivantes :
- déterminer une valeur de recalage égale à la valeur absolue la plus élevée parmi les données négatives de mesure ;
- ajouter la valeur de recalage à chacune des données de mesure ; et
- inclure dans l'entête une information représentative de la valeur de recalage.

10. Procédé selon l'une quelconque des revendications 1 à 9, **caractérisé en ce que**, pour mettre à disposition lesdites données de mesure, le compteur électrique s'attendant à recevoir un mot de passe prédéfini, ledit compteur électrique effectue les étapes suivantes :
- recevoir (S501) un mot de passe ;
- déterminer (S502) une valeur inversée du mot de passe reçu ;
- mettre à disposition (S505) lesdites données de mesure sous forme compressée, lorsque la valeur inversée du mot de passe reçu correspond audit mot de passe prédéfini ; et
- mettre à disposition (S510) lesdites données de mesure sous forme non compressée, lorsque le mot de passe reçu correspond audit mot de passe prédéfini.

11. Programme d'ordinateur, **caractérisé en ce qu'**il comprend des instructions pour mettre en œuvre, par un compteur électrique, le procédé selon l'une quelconque des revendications 1 à 10, lorsque ledit programme est exécuté par un processeur dudit compteur électrique.

12. Moyens de stockage, **caractérisés en ce qu'**ils stockent un programme d'ordinateur comprenant des instructions pour mettre en œuvre, par un compteur électrique, le procédé selon l'une quelconque des revendications 1 à 10, lorsque ledit programme est exécuté par un processeur dudit compteur électrique.

13. Compteur électrique (120) adapté pour mettre à disposition des données de mesure, lesdites données étant issues de mesures de quantité d'énergie électrique effectuées par ledit compteur électrique sur une consommation énergétique d'une installation électrique supervisée par ledit compteur électrique, le compteur électrique comportant des moyens pour récupérer les données de mesure à mettre à disposition, **caractérisé en ce que** le compteur électrique comporte en outre :
- des moyens pour classifier (S405, S407) chaque donnée récupérée, en fonction d'un nombre minimum de bits pour représenter ladite donnée ;
- des moyens pour déterminer (S404, S406), pour chaque classe d'une pluralité prédéfinie de classes, un nombre de bits affectés pour représenter chaque donnée classifiée dans ladite classe égal au maximum des nombres minimums de bits déterminés pour les données classifiées dans ladite classe ;
- des moyens pour compresser (S306 ; S408) chaque donnée de mesure récupérée, en représentant ladite donnée récupérée sur un nombre de bits égal au nombre de bits affectés à la classe de ladite donnée et en insérant avant la donnée compressée un préfixe prédéfini associé à ladite classe ; et
- des moyens pour inclure (S307) dans un entête associé aux données compressées, pour chaque classe, une information représentative du nombre de bits affectés pour représenter chaque donnée classifiée dans ladite classe,
et **caractérisé en ce que** le compteur électrique comporte en outre :
- des moyens pour déterminer (S401) la valeur la plus récurrente parmi les données de mesure récupérées ; et
- des moyens pour remplacer (S408) les données de mesure, de valeur égale à la valeur la plus récurrente déterminée, par un unique bit.

## Patentansprüche

1. Verfahren zur Bereitstellung, durch einen Elektrizitätszähler (120), von Messdaten, wobei die Daten aus Messungen einer Menge an elektrischer Energie stammen, die durch den Elektrizitätszähler bezüglich eines Energieverbrauchs einer elektrischen Anlage, die durch den Elektrizitätszähler überwacht wird, durchgeführt werden, wobei der Elektrizitätszähler die bereitzustellenden Messdaten sammelt (S302), **dadurch gekennzeichnet, dass** der Elektrizitätszähler ferner die folgenden Schritte durchführt:
- Klassifizieren (S405, S407) jedes gesammelten Datenelements in Abhängigkeit von einer Mindestanzahl von Bits zur Darstellung des Datenelements;
- Bestimmen (S404, S406), für jede Klasse einer vordefinierten Vielzahl von Klassen, einer Anzahl von zugewiesenen Bits zur Darstellung jedes in der Klasse klassifizierten Datenelements, die dem Maximum der bestimmten Mindestanzahlen von Bits für die in der Klasse klassifizierten Daten entspricht;
- Komprimieren (S306; S408) jedes gesammelten Messdatenelements durch Darstellen des gesammelten Messdatenelements mit einer Anzahl von Bits, die der Anzahl von der Klasse des Messdatenelements zugewiesenen Bits entspricht, und durch Einfügen eines vordefinierten Präfixes, der mit der Klasse assoziiert ist, vor dem komprimierten Datenelement; und
- Einschließen (S307), in einem Header, der mit den komprimierten Daten assoziiert ist, für jede Klasse, einer Information, die für die Anzahl von zugewiesenen Bits zur Darstellung jedes in der Klasse klassifizierten Datenelements repräsentativ ist,
und **dadurch gekennzeichnet, dass** der Elektrizitätszähler die folgenden Schritte durchführt:
- Bestimmen (S401) des Werts, der innerhalb der gesammelten Messdaten am häufigsten auftritt; und
- Ersetzen (S408) der Messdaten, die einen Wert aufweisen, der dem bestimmten, am häufigsten auftretenden Wert entspricht, durch ein einziges Bit.

2. Verfahren nach Anspruch 1, **dadurch gekennzeichnet, dass**, wenn die Messdaten in absoluter Form dargestellt werden, der Elektrizitätszähler einen Vorabschritt des Umwandelns (S305) der Messdaten in absoluter Form in Messdaten in relativer Form durchführt.

3. Verfahren nach Anspruch 1, **dadurch gekennzeichnet, dass** der Elektrizitätszähler einen verkürzten Binärcode verwendet, um die Messdaten, die den am häufigsten auftretenden Wert aufweisen, und die Präfixe zu identifizieren.

4. Verfahren nach einem der Ansprüche 1 bis 3, **dadurch gekennzeichnet, dass**, wenn die Messdaten mit mindestens einer Zeitstempelinformation assoziiert sind, die für einen absoluten Zeitpunkt repräsentativ ist, der Elektrizitätszähler einen Schritt des Umwandelns (S303) der Zeitstempelinformation in eine in Bezug auf ein vordefiniertes Datum relative Information durchführt.

5. Verfahren nach einem der Ansprüche 1 bis 4, **dadurch gekennzeichnet, dass**, wenn jedes Messdatenelement mit einer Zeitstempelinformation assoziiert ist und die durch den Elektrizitätszähler durchgeführten Messungen periodisch sind, der Elektrizitätszähler nur eine Zeitstempelinformation aufbewahrt und in dem Header eine Information, die für die Periodizität der Messungen repräsentativ ist, einschließt.

6. Verfahren nach Anspruch 5, **dadurch gekennzeichnet, dass** zum Angeben einer Änderung einer Zeitreferenz innerhalb der Messdaten der Elektrizitätszähler die folgenden Schritte durchführt:
- Bestimmen eines Indexes jedes Messdatenelements, bei dem die Zeitreferenzänderung gegriffen hat;
- Bestimmen eines Zeitversatzes aufgrund der Zeitreferenzänderung für das Messdatenelement, dessen Index auf diese Weise bestimmt wurde; und
- Einschließen, in dem Header, von Informationen, die für den Index und den Zeitversatz repräsentativ sind.

7. Verfahren nach einem der Ansprüche 1 bis 6, **dadurch gekennzeichnet, dass** der Elektrizitätszähler, wenn die Messdaten als Daten ohne Vorzeichen betrachtet werden, die folgenden Schritte durchführt:
- Bestimmen (S404) einer Mindestanzahl von Bits zur Darstellung des höchsten Werts innerhalb der Messdaten;
- Zuweisen (S405) der bestimmten Mindestanzahl von Bits zu einer ersten Klasse;
- Prüfen, für jede andere Klasse der vordefinierten Vielzahl, eines Werts von zugewiesenen Bits zur Darstellung der Daten der Klasse und Bestimmen einer sich daraus ergebenden Größe der Messdaten nach einer Komprimierung; und
- Zuweisen, zu jeder anderen Klasse der vordefinierten Vielzahl, einer Anzahl von Bits, die es gestattet, nach einer Komprimierung die kleinste sich daraus ergebende Größe der Messdaten zu erhalten.

8. Verfahren nach einem der Ansprüche 1 bis 6, **dadurch gekennzeichnet, dass**, wenn die Messdaten ein Vorzeichen aufweisen, der Elektrizitätszähler die folgenden Schritte durchführt:
- Bestimmen einer ersten Mindestanzahl von Bits zur Darstellung des höchsten absoluten Werts innerhalb der positiven Messdaten;
- Bestimmen einer zweiten Mindestanzahl von Bits zur Darstellung des höchsten absoluten Werts innerhalb der negativen Messdaten;
- Zuweisen der bestimmten ersten Mindestanzahl von Bits zu einer ersten Klasse;
- Zuweisen der bestimmten zweiten Mindestanzahl von Bits zu einer zweiten Klasse;
- Prüfen, für jede andere Klasse der vordefinierten Vielzahl, eines Werts von zugewiesenen Bits zur Darstellung der Daten der Klasse und Bestimmen einer sich daraus ergebenden Größe der Messdaten nach einer Komprimierung;
- Zuweisen, zu jeder anderen Klasse der vordefinierten Vielzahl, einer Anzahl von Bits, die es gestattet, nach einer Komprimierung die kleinste sich daraus ergebende Größe der Messdaten zu erhalten; und
- Einschließen, in dem Header, einer Information, die angibt, welche Klasse(n) positive Messdaten betrifft/betreffen und welche Klasse(n) negative Messdaten betrifft/betreffen.

9. Verfahren nach einem der Ansprüche 1 bis 6, **dadurch gekennzeichnet, dass**, wenn die Messdaten ein Vorzeichen aufweisen, der Elektrizitätszähler vorab die folgenden Schritte durchführt:
- Bestimmen eines Korrekturwerts, der dem höchsten absoluten Wert innerhalb der negativen Messdaten entspricht;
- Hinzufügen des Korrekturwerts zu jedem der Messdaten; und
- Einschließen, in dem Header, einer Information, die für den Korrekturwert repräsentativ ist.

10. Verfahren nach einem der Ansprüche 1 bis 9, **dadurch gekennzeichnet, dass**, wenn der Elektrizitätszähler zum Bereitstellen der Messdaten darauf wartet, ein vordefiniertes Passwort zu empfangen, der Elektrizitätszähler die folgenden Schritte durchführt:
- Empfangen (S501) eines Passworts;
- Bestimmen (S502) eines invertierten Werts des empfangenen Passworts;
- Bereitstellen (S505) der Messdaten in komprimierter Form, wenn der invertierte Wert des empfangenen Passworts dem vordefinierten Passwort entspricht; und
- Bereitstellen (S510) der Messdaten in nicht komprimierter Form, wenn das empfangene Passwort dem vordefinierten Passwort entspricht.

11. Computerprogramm, **dadurch gekennzeichnet, dass** es Anweisungen zur Umsetzung, durch einen Elektrizitätszähler, des Verfahrens nach einem der Ansprüche 1 bis 10 beinhaltet, wenn das Programm durch einen Prozessor des Elektrizitätszählers ausgeführt wird.

12. Speichermittel, **dadurch gekennzeichnet, dass** sie ein Computerprogramm speichern, das Anweisungen zur Umsetzung, durch einen Elektrizitätszähler, des Verfahrens nach einem der Ansprüche 1 bis 10 beinhaltet, wenn das Programm durch einen Prozessor des Elektrizitätszählers ausgeführt wird.

13. Elektrizitätszähler (120), der dazu angepasst ist, Messdaten bereitzustellen, wobei die Daten aus Messungen einer Menge an elektrischer Energie stammen, die durch den Elektrizitätszähler bezüglich eines Energieverbrauchs einer elektrischen Anlage, die durch den Elektrizitätszähler überwacht wird, durchgeführt werden, wobei der Elektrizitätszähler Mittel zum Sammeln der bereitzustellenden Messdaten umfasst, **dadurch gekennzeichnet, dass** der Elektrizitätszähler ferner Folgendes umfasst:
- Mittel zum Klassifizieren (S405, S407) jedes gesammelten Datenelements in Abhängigkeit von einer Mindestanzahl von Bits zur Darstellung des Datenelements;
- Mittel zum Bestimmen (S404, S406), für jede Klasse einer vordefinierten Vielzahl von Klassen, einer Anzahl von zugewiesenen Bits zur Darstellung jedes in der Klasse klassifizierten Datenelements, die dem Maximum der bestimmten Mindestanzahlen von Bits für die in der Klasse klassifizierten Daten entspricht;
- Mittel zum Komprimieren (S306; S408) jedes gesammelten Messdatenelements durch Darstellen des gesammelten Datenelements mit einer Anzahl von Bits, die der Anzahl von der Klasse des Datenelements zugewiesenen Bits entspricht, und durch Einfügen eines vordefinierten Präfixes, der mit der Klasse assoziiert ist, vor dem komprimierten Datenelement; und
- Mittel zum Einschließen (S307), in einem Header, der mit den komprimierten Daten assoziiert ist, für jede Klasse, einer Information, die für die Anzahl von zugewiesenen Bits zur Darstellung jedes in der Klasse klassifizierten Datenelements repräsentativ ist,
und **dadurch gekennzeichnet, dass** der Elektrizitätszähler ferner Folgendes umfasst:
- Mittel zum Bestimmen (S401) des Werts, der innerhalb der gesammelten Messdaten am häufigsten auftritt; und
- Mittel zum Ersetzen (S408) der Messdaten, die einen Wert aufweisen, der dem bestimmten, am häufigsten auftretenden Wert entspricht, durch ein einziges Bit.

## Claims

1. Method for making measurement data available by an electrical meter (120), said data coming from electrical energy quantity measurements carried out by said electrical meter on an energy consumption of an electrical installation monitored by said electrical meter, the electrical meter retrieving (S302) the measurement data to be made available, **characterized in that** the electrical meter further carries out the following steps:
- classifying (S405, S407) each retrieved datum according to a minimum number of bits to represent said datum;
- determining (S404, S406), for each class of a predefined plurality of classes, a number of bits allocated to represent each datum classified in said class equal to the maximum of the minimum numbers of bits determined for the data classified in said class;
- compressing (S306; S408) each retrieved measurement datum, by representing said retrieved measurement datum on a number of bits equal to the number of bits allocated to the class of said measurement datum and by inserting, in front of the compressed datum, a predefined prefix associated with said class; and
- including (S307), in a header associated with the compressed data, for each class, information representative of the number of bits allocated to represent each datum classified in said class,
and **characterized in that** the electrical meter carries out the following steps:
- determining (S401) the most recurring value among the retrieved measurement data; and
- replacing (S408) the measurement data, having a value equal to the determined most recurring value, with a single bit.

2. Method according to Claim 1, **characterized in that**, with the measurement data being represented in absolute form, the electrical meter carries out a prior step of converting (S305) the measurement data in absolute form into measurement data in relative form.

3. Method according to Claim 1, **characterized in that** the electrical meter uses a truncated binary code to identify the measurement data having said most recurring value and the prefixes.

4. Method according to any one of Claims 1 to 3, **characterized in that**, with the measurement data being associated with at least one item of timestamp information representative of an absolute time, the electrical meter carries out a step of converting (S303) said timestamp information into relative information with respect to a predefined date.

5. Method according to any one of Claims 1 to 4, **characterized in that**, with each measurement datum being associated with an item of timestamp information, and with the measurements carried out by the electrical meter being periodic, the electrical meter retains only an item of timestamp information and includes, in the header, information representative of the periodicity of said measurements.

6. Method according to Claim 5, **characterized in that**, to indicate a change in time reference among the measurement data, the electrical meter carries out the following steps:
- determining an index of each measurement datum for which the change in time reference occurred;
- determining a time offset due to the change in time reference for said measurement datum the index of which has been determined in this way; and
- including, in the header, information representative of said index and of said time offset.

7. Method according to any one of Claims 1 to 6, **characterized in that** the electrical meter, considering the measurement data to be unsigned data, carries out the following steps:
- determining (S404) a minimum number of bits to represent the highest value among the measurement data;
- allocating (S405) said determined minimum number of bits to a first class;
- testing, for each other class of said predefined plurality, a value of bits allocated to represent the data of said class, and determining a resulting size of the measurement data after compression; and
- allocating to each other class of said predefined plurality a number of bits making it possible to obtain the smallest resulting size of the measurement data after compression.

8. Method according to any one of Claims 1 to 6, **characterized in that**, with the measurement data being signed, the electrical meter carries out the following steps:
- determining a first minimum number of bits to represent the highest absolute value among the positive measurement data;
- determining a second minimum number of bits to represent the highest absolute value among the negative measurement data;
- allocating said determined first minimum number of bits to a first class;
- allocating said determined second minimum number of bits to a second class;
- testing, for each other class of said predefined plurality, a value of bits allocated to represent the data of said class, and determining a resulting size of the measurement data after compression;
- allocating to each other class of said predefined plurality a number of bits making it possible to obtain the smallest resulting size of the measurement data after compression; and
- including, in the header, information indicating which class(es) concern(s) positive measurement data and which class(es) concern(s) negative measurement data.

9. Method according to any one of Claims 1 to 6, **characterized in that**, with the measurement data being signed, the electrical meter carries out the following steps beforehand:
- determining a readjustment value equal to the highest absolute value among the negative measurement data;
- adding the readjustment value to each of the measurement data; and
- including, in the header, information representative of the readjustment value.

10. Method according to any one of Claims 1 to 9, **characterized in that**, to make said measurement data available, and with the electrical meter waiting to receive a predefined password, said electrical meter carries out the following steps:
- receiving (S501) a password;
- determining (S502) an inverted value of the received password;
- making (S505) said measurement data available in compressed form when the inverted value of the received password corresponds to said predefined password; and
- making (S510) said measurement data available in uncompressed form when the received password corresponds to said predefined password.

11. Computer program, **characterized in that** it comprises instructions for implementing, by an electrical meter, the method according to any one of Claims 1 to 10 when said program is executed by a processor of said electrical meter.

12. Storage means, **characterized in that** they store a computer program comprising instructions for implementing, by an electrical meter, the method according to any one of Claims 1 to 10 when said program is executed by a processor of said electrical meter.

13. Electrical meter (120) designed to make measurement data available, said data coming from electrical energy quantity measurements carried out by said electrical meter on an energy consumption of an electrical installation monitored by said electrical meter, the electrical meter comprising means for retrieving the measurement data to be made available, **characterized in that** the electrical meter further comprises:
- means for classifying (S405, S407) each retrieved datum according to a minimum number of bits to represent said datum;
- means for determining (S404, S406), for each class of a predefined plurality of classes, a number of bits allocated to represent each datum classified in said class equal to the maximum of the minimum numbers of bits determined for the data classified in said class;
- means for compressing (S306; S408) each retrieved measurement datum, by representing said retrieved datum on a number of bits equal to the number of bits allocated to the class of said datum and by inserting, in front of the compressed datum, a predefined prefix associated with said class; and
- means for including (S307), in a header associated with the compressed data, for each class, information representative of the number of bits allocated to represent each datum classified in said class,
and **characterized in that** the electrical meter further comprises:
- means for determining (S401) the most recurring value among the retrieved measurement data; and
- means for replacing (S408) the measurement data, having a value equal to the determined most recurring value, with a single bit.
